# EUROPEAN PATENT SPECIFICATION

(11) **EP 2 719 606 B1**
(45) Date of publication and mention of the grant of the patent: **09.09.2015**
(21) Application number: 13188399.3
(22) Date of filing: 11.10.2013
(51) Int. Cl.: F16K 31/04, B62D 5/04, G01R 31/34, H02P 29/02, F16K 1/22

(54) **Method and device for testing an electric motor for an actuator of an internal combustion engine**
Verfahren und Vorrichtung zum Testen eines Elektromotors für ein Stellglied eines Verbrennungsmotors
Procédé et dispositif pour contrôler un moteur électrique pour l'actionneur d'un moteur à combustion interne

(30) Priority: 12.10.2012 IT BO20120560; 12.10.2012 IT BO20120561
(43) Date of publication of application: 16.04.2014
(73) Proprietor: Magneti Marelli S.p.A., Corbetta (MI) (IT)
(72) Inventor: Facciolo, Fabio, 47122 Pievequinta (IT); Greco, Marco, 40017 San Giovanni in Persiceto (IT)
(74) Representative: Maccagnan, Matteo

(56) References cited:
- US-A- 5 898 288
- US-A1- 2001 019 660
- US-A1- 2002 022 914
- US-A1- 2012 001 580
- US-B1- 6 456 946

## Description

### TECHNICAL FIELD

The present invention relates to a method, software and device for testing an electric motor for an actuator of an internal combustion engine.

### PRIOR ART

A throttle valve, which is arranged upstream of an intake manifold and adjusts the flow rate of the air which is fed to the cylinders, is normally provided in internal combustion engines. A throttle valve of the typical, currently marketed type has a valve body provided with a tubular feeding pipe, through which the air aspirated by the internal combustion engine flows; a throttle valve plate, which is fitted onto a rotating shaft to rotate between an opening position and a closing position of the feeding pipe, is housed within the feeding pipe. The rotation of the throttle valve plate is controlled by an actuator device normally comprising an electric motor coupled to the throttle valve plate shaft by means of a gear drive and at least one spring which pushes the throttle valve plate shaft either to the closing position (or rather towards a limp-home position close to the closing position in gasoline applications) or to an opening position (in diesel applications).

The presence of any faults of the electric motor of the throttle valve needs to be checked during the step of installing the throttle valve. The step of testing the electric motor typically occurs during a preliminary step of adjusting, when the electric motor is installed in the valve body but is not yet connected to the transmission to establish whether the electric motor is functionally suitable and the installation of the valve body may be thus completed.

Testing methods of the electric motors for actuators of an internal combustion engine are known, for example, from documents US-A-6456946 and US-A-2001/019660. Said testing methods are applied when the electric motors are already installed on the actuator and thus inaccessible and not connectable to instruments, are rather unreliable because they allow to identify only some of the possible faults which may occur in an electric motor.

### DESCRIPTION OF THE INVENTION

It is the object of the present invention to provide a method for testing an electric motor for an actuator of an internal combustion engine, which method is free from the drawbacks of the prior art, reliable and easy and cost-effective to be implemented.

According to the present invention a method for testing an electric motor for an actuator of an internal combustion engine is provided as claimed in claim 1 and in any one of the subsequent claims depending on claim 1.

### BRIEF DESCRIPTION OF THE DRAWINGS

The present invention will now be described with reference to the accompanying drawings, which show a non-limitative embodiment thereof, in which:
- figure 1 is a partially exploded perspective view, with parts removed for clarity, of a throttle valve provided with an electric motor which is tested by means of the device made in accordance with the present invention;
- figure 2 is a front view, with parts removed for clarity, of the throttle valve in figure 1;
- figure 3 shows a testing device of an electric motor for an actuator of an internal combustion engine made according to the present invention; and
- figure 4 shows the pattern of the electromotive force and of the current signal during the step of testing implemented by the testing device in figure 3.

### PREFERRED EMBODIMENTS OF THE INVENTION

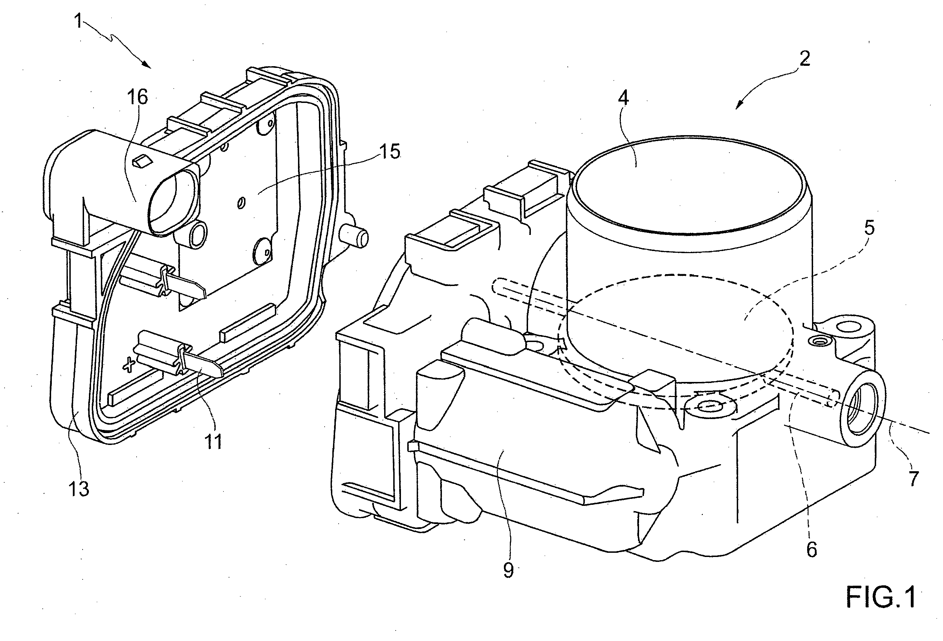

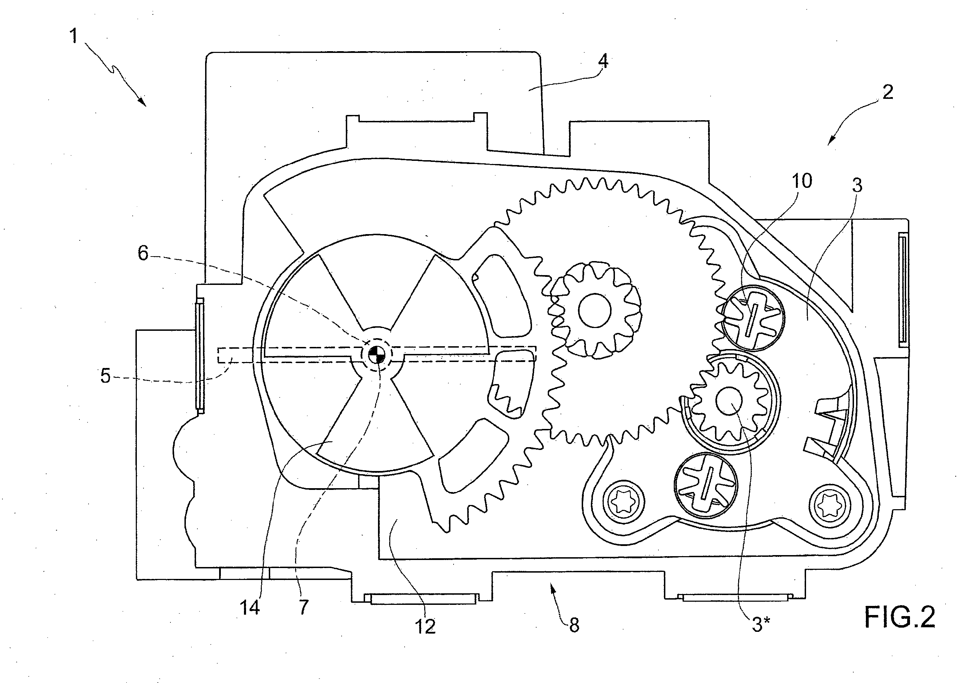

In figures 1 and 2, numeral 1 indicates as a whole an electronically controlled throttle valve for an internal combustion engine (not shown). Throttle valve 1 comprises a valve body 2 accommodating an electric motor 3 (shown in figure 2) provided with a pinion 3*, a tubular circular section feeding pipe 4 through which the air aspirated by the internal combustion engine flows, and a throttle valve plate 5 (diagrammatically shown with a dashed line), which is circular in shape, engages the feeding pipe 4 and rotates between an opening position and a closing position of the feeding pipe 4 under the bias of the actuator device. The throttle valve plate 5 is fitted onto a shaft 6 having a longitudinal rotation axis 7 to rotate between the opening position and the closing position under the bias of the actuator device.

As shown in figure 2, the actuator device comprises the electric motor 3, the pinion 3* of which is coupled to the shaft 6 itself by means of a gear drive 8, a return spring (not shown and coupled to shaft 6) adapted to rotate the throttle valve 5 towards the stroke end position (which corresponds to the closing position in gasoline applications), and according to a variant for gasoline applications, a contrast spring (not shown and coupled to shaft 6) adapted to rotate the throttle valve plate 5 towards a partial opening or limp-home position defined by a stopper body (not shown) against the bias of the return spring.

Electric motor 3 has a cylindrical body, which is arranged in a tubular housing 9 (shown in figure 1) of the valve body 2 arranged by the side of the feeding duct 4 and is maintained in a determined position in the tubular housing 9 by a metal plate 10 provided with a pair of female electric connectors 10 (shown in figure 2), which are electrically connected to the electric motor 3 and are adapted to be engaged by a pair of respective male electric connectors 11 (shown in figure 1).

Gear drive 8 is arranged in a chamber 12 (shown in figure 2) of the valve body 2, which is closed by a removable lid 13 (shown in figure 1).

As shown in figures 1 and 2, the throttle valve 1 comprises a position sensor 25, preferably of the contactless inductive type, which is coupled to the shaft 6 and is adapted to detect the angular position of the shaft 6 and thus of the throttle valve plate 5, to allow a feedback control of the position of the throttle valve plate 5 itself. The position sensor comprises a rotor 14 (shown in figure 2) integral with shaft 6 and a stator 15 (shown in figure 1) supported by lid 13 and arranged facing rotor 14 in use.

As shown in figure 1, lid 13 is provided with a female electric connector 16, which comprise a series of electric contacts (not shown in detail): two electric contacts are connected to the male electric connectors 11 and adapted to supply the electric motor 3, while the other electric contacts are connected to the stator 15 of the position sensor.

The device and method of testing the electric motor 3 of the throttle valve 1 are described below. The step of testing the electric motor is typically occurs during a preliminary step of adjusting, i.e. in an intermediate step of installing the throttle valve 1, when the electric motor 3 is installed in the tubular housing 9 of the valve body 2 and pinion 3* of the electric motor 3 is not yet engaged by the transmission and is thus free to rotate without any mechanical load.

The step of testing the electric motor 3 is carried out to establish whether the electric motor 3 after installation in the tubular housing 9 of the valve body 2 is functionally suitable and whether the installation of the throttle valve 1 may be continued/completed.

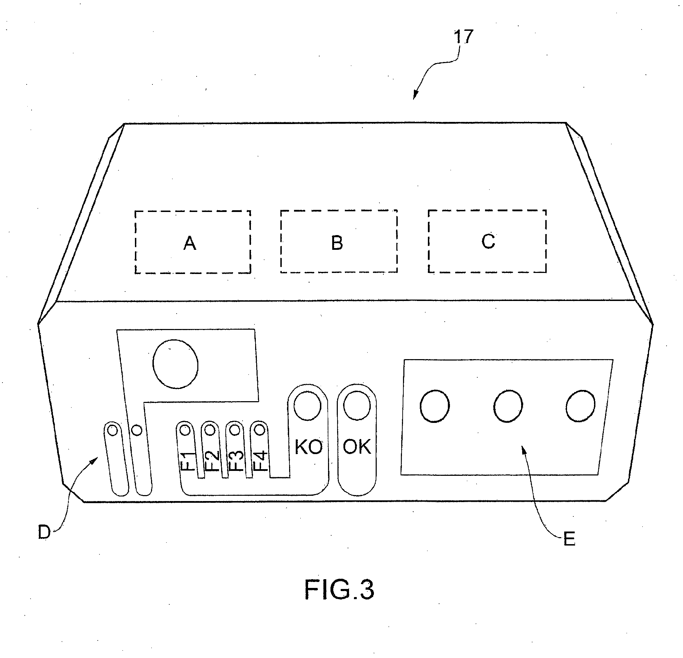

The step of testing the electric motor 3 is carried out by means of a testing device, shown in figure 3 and indicated by reference numeral 17 to establish whether the electric motor 3, installed in the tubular housing 9 of the valve body 2, is free from malfunctioning and is suitable to proceed with the installation of the throttle valve 1.

As better shown in figure 3, the production line of the throttle valves 1 comprises a testing device 17 substantially comprising four parts:
- a communication unit A which is connected to the production line of the throttle valve 1 and is configured to receive and/or transmit information from/to the production line;
- a supply unit B of the electric motor 3 provided to supply a predetermined voltage impulse to the electric motor 3 for a predetermined time;
- a control unit C of the operating parameters of the electric motor 3 during the step of testing the electric motor 3 itself;
- an external interface unit D with an operator of the testing device 17 for either checking or manually monitoring the step of testing and for viewing the results of the step of testing; and
- a communication unit E with an optional instrument for viewing the voltage/current of the electric motor during the step of testing.

The testing method includes the communication unit A which is connected to the production line of the throttle valve 1 receiving a signal from the production line of the throttle valve 1 itself related to the type of electric motor 3 to be subjected to the testing process and a subsequent signal adapted to control the starting of the step of testing on the electric motor 3.

In particular, the communication unit A is connected to the supply unit B in order to transmit the start signal of the step of testing on the electric motor 3. The supply unit B is, in turn, configured to control a brief voltage impulse to the electric motor 3 to be tested. The duration and amplitude of the voltage impulse to be supplied to the electric motor 3 are chosen during a preliminary step of setting and adjusting the step of testing and according to the type of electric motor 3 to be tested.

In particular, the duration of the voltage impulse to be supplied to the electric motor 3 is defined by observing the transient pattern of the filtered current (on a sample of electric motor 3 compliant with specifications). It has been observed that, having exhausted the initial peak caused by the acceleration of the electric motor 3 and the consequent reaching of the idle speed (without any applied mechanical load), the pattern of the current then tends to decrease and eventually stabilize within a few seconds. This stabilization time is related to the gradual decrease of internal frictions of the electric motor 3.

Generally, the amplitude of the voltage impulse to be supplied to the electric motor 3 is instead from 1/3 and 1/2 of the nominal supply voltage of the electric motor 3. The purpose of a low voltage supply as compared to the nominal voltage value is to provide less energy to the electric motor 3 to allow a greater influence of the irregularities and of the mechanical frictions on the filtered current. The amplitude of the voltage impulse to be supplied to the electric motor 3 is thus defined by observing the pattern of the filtered current on a sample of electric motors 3 which do not comply with specifications, and researching the maximum influence of irregularities caused by internal frictions of the electric motor 3 on the filtered current.

Before starting the testing process, the production line will communicate the type of electric motor 3 to be tested to the communication unit A; thereby, the communication unit B will be able to determine both the correct voltage to be supplied and the tolerance values (which will be better described below). According to a further variant, the information on the correct voltage to be supplied and the tolerance values (which will be better described below) are supplied from the production line directly to the testing device 17.

According to a first variant, the duration and amplitude of the voltage impulse to be supplied to the electric motor 3 are constant.

According to a second variant, the duration and amplitude of the voltage impulse to be supplied to the electric motor 3 are predetermined and preferably variable as a function of the type of electric motor 3 to be tested.

In particular, it has been experimentally tested that a duration of a few seconds of the voltage impulse to be supplied to the electric motor 3 allows to limit the duration of the step of testing while allowing to reliably test the electric motor 3.

According to a preferred variant, the duration of the voltage impulse to be supplied to the electric motor 3 is either equal to or slightly shorter than three seconds.

Furthermore, it was empirically checked that an amplitude of the voltage impulse to be supplied to the electric motor 3 lower than the nominal supply voltage of the electric motor 3 allows to highlight possible mechanical faults present in the electric motor 3 more easily. According to a preferred embodiment, the electric motor 3 is powered at a voltage of 4 volts.

The testing device 17 is provided to monitor the trend of the current signal in the electric motor 3 during the supply of the voltage impulse. In particular, the testing device 17 is set up to ignore the initial transient and warm-up step and to monitor the pattern of the current in the electric motor 3 during a final step of said voltage impulse which is long enough to allow at least one complete revolution of the pinion 3* of the electric motor 3.

The duration of the final step of monitoring said voltage impulse is established in a preliminary step of setting and adjusting. According to a preferred variant, the duration and amplitude of the voltage impulse to be supplied to the electric motor 3 are constant.

According to a preferred variant, the duration of the final step of the voltage impulse to be supplied to the electric motor 3 to be tested is defined by observing a batch of electric motors 3 with the same features as the electric motor 3 to be tested, but which do not comply with specifications, during a preliminary step of setting the method. A minimum necessary time for a complete 360° revolution of the pinions 3* of the electric motors 3 to be completed is determined by observing the batch of electric motors 3 with the same features as the electric motor 3 to be tested but which do not comply with specifications; such a minimum time is then doubled as a precautionary measure to determine the duration of the final step of the voltage impulse to be supplied to the electric motor 3.

In particular, the duration of the final step of the voltage impulse to be supplied to the electric motor 3 is of 40 milliseconds. It has been empirically tested that a duration of the final step of the voltage impulse to be supplied to the electric motor 3 from 30 to 50 milliseconds, and preferably of 40 milliseconds, is limited but allows however to cover some revolutions of the pinion 3* of the electric motor 3 completely.

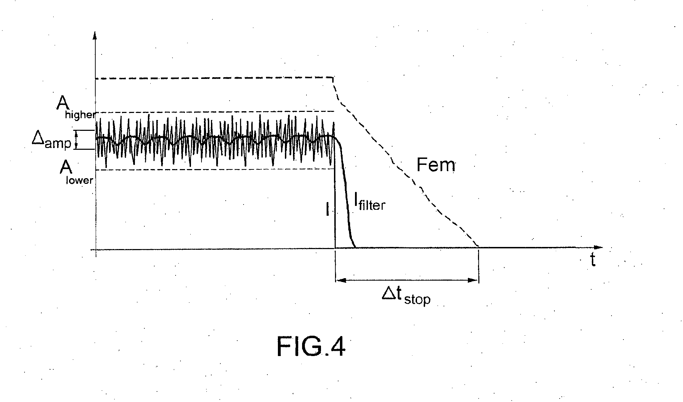

The method thus includes filtering the current signal in the electric motor 3 during the supply of the voltage impulse. In particular, the step of filtering occurs at a relatively low cut-off frequency, and preferably of the order of 40 Hz. Furthermore, according to a preferred embodiment also shown in figure 4, the step of filtering is implemented by means of a filter with a high gradient, preferably an eighth-order Bessel filter. It has thus been empirically checked that the filter with such a high gradient and with an adequate cut-off frequency allows, on one hand, to cancel the physiological interferences caused by the current switching phenomena (mainly related to the brushe and collector assembly) but, on the other hand, allows to highlight the current undulations caused either by mechanical irregularities of the components of the electric motor 3 or by incorrect or improper installation.

Once the current signal of the electric motor 3 during the supply of the voltage impulse as been appropriately filtered, the testing method includes processing said filtered current signal in the electric motor 3.

In particular, the testing method includes calculating a first characteristic parameter of the current signal of the electric motor 3. Such a first characteristic parameter corresponds to the average current value of the current signal of the electric motor 3 during the final step of said voltage impulse.

Furthermore, the testing method includes calculating a second characteristic parameter of the current signal of the electric motor 3. Such a second characteristic parameter corresponds to the amplitude of the oscillation of the current signal of the electric motor 3 during the final step of said voltage impulse.

During a preliminary step of setting and adjusting, a lower threshold value I_{lower} and a higher threshold value I_{higher} of the average current value of the current signal of the electric motor 3 are determined in the final step of said voltage impulse, such threshold values are selected according to the type of electric motor 3 that the production line communicates to the testing device 17 before starting the step of testing.

According to a first variant, said lower threshold values I_{lower} and higher threshold value I_{higher} of the average current value of the current signal of the electric motor 3 are constant.

According to a second variant, said lower threshold s I_{lower} and higher threshold value I_{higher} of the average current signal of the electric motor 3 are variable over time and are determined as a function of a plurality of parameters, such as, for example, the testing voltage, the ambient temperature, the duration of the voltage impulse, the number of times in which the testing process is repeated if the electric motor 3 is identified as unsuitable.

The testing method thus includes comparing the average current value of the current signal of the electric motor 3 during the final step of said voltage impulse and both the lower threshold valve I_{lower} and the higher threshold value I_{higher}.

Three conditions may occur as a result of the comparison of the average current value of the current signal of the electric motor 3 during the final step of the voltage impulse with the lower threshold value I_{lower} and the higher threshold value I_{higher}:
- if the average current value of the current signal of the electric motor 3 during the final step of the voltage impulse is in the range defined by the lower threshold value I_{lower} and by the higher threshold value I_{higher}, no fault related to the average current value of the current signal of the electric motor 3 in the final step of said voltage impulse is identified;
- if the average current value of the current signal of the electric motor 3 during the final step of the voltage impulse is lower than the lower threshold value I_{lower}, a fault related to the average current value of the current signal of the electric motor 3 in the final step of said voltage impulse is identified; and
- if the average current value of the current signal of the electric motor 3 during the final step of the voltage impulse is higher than the higher threshold value I_{higher}, a fault related to the average current value of the current signal of the electric motor 3 in the final step of said voltage impulse is identified.

In particular, if the average current value is lower than the lower threshold value I_{lower} it means that the electric motor 3 has electric problems, such as, for example, a high contact resistance or interrupted rotor windings.

Instead, if the average current value is higher than the higher threshold value I_{higher} it means that the electric motor 3 has an electric problem (such as a short circuit, for example) or high internal frictions.

Furthermore, a maximum amplitude Δₐₘₚ of the oscillation of the filtered current signal of the electric motor 3 in the final step of the voltage impulse is determined in a preliminary step of setting and adjusting. Such a maximum amplitude Δₐₘₚ of the oscillation of the current signal of the electric motor 3 in the final step of the voltage impulse has a predetermined amplitude as a function of the type of electric motor 3 that the production line communicates to the testing device 17 before starting the step of testing. According to a first variant, the maximum amplitude Δₐₘₚ of the oscillation of the current signal of the electric motor 3 in the final step of the voltage impulse is constant and as a function of the type of electric motor 3. According to a second variant, the amplitude of the range of safety values is variable over time and the determination of the maximum amplitude Δₐₘₚ of the oscillation of the current signal of the electric motor 3 in the final step of the voltage impulse occurs as a function of a plurality of parameters such as, for example, the test voltage, the ambient temperature, the voltage impulse duration, the number of times in which the testing process is repeated if the electric motor 3 is identified are unsuitable.

Then, the testing method thus includes comparing the amplitude of the oscillation of the current signal of the electric motor 3 in the final step of the voltage impulse with the maximum amplitude Δₐₘₚ of the oscillation of the current signal of the electric motor 3 in the final step of the voltage impulse.

Two conditions may occur as a function of the result of the comparison of the amplitude of the oscillation of the current signal of the electric motor 3 in the final step of the voltage impulse with the maximum amplitude Δₐₘₚ of the oscillation of the current signal of the electric motor 3 in the final step of the voltage impulse:
- if the amplitude of the oscillation of the current signal of the electric motor 3 in the final step of the voltage impulse is either lower than or equal to the maximum amplitude Δₐₘₚ of the oscillation of the current signal of the electric motor 3 in the final step of the voltage impulse, no fault on the oscillation of the current signal of the electric motor 3 in the final step of the voltage impulse is identified; and
- on the other hand, the amplitude of the oscillation of the current signal of the electric motor 3 in the final step of the voltage impulse is higher than the maximum amplitude Δₐₘₚ of the oscillation of the current signal of the electric motor 3 in the final step of the voltage impulse, a fault on the oscillation of the current signal of the electric motor 3 in the final step of the voltage impulse is identified.

In particular, if the amplitude of the oscillation of the current signal of the electric motor 3 in the final step of the voltage impulse is higher than the maximum amplitude Δₐₘₚ of the oscillation of the current signal of the electric motor 3 in the final step of the voltage impulse, it means that the electric motor 3 has irregular frictions or frictions located in fractions of the round angle (e.g. such as sticking points).

At the end of the final step of monitoring the voltage impulse (i.e. when the voltage supply is interrupted), the electric motor 3 clearly continues to rotate by inertia until it stops completely once a stop time interval has elapsed and once all the kinetic energy stored when the voltage impulse was supplied by internal friction has been dissipated.

The testing method thus includes monitoring the pattern of the electromotive force generated by the electric motor 3.

In particular, the testing method includes evaluating the decay of the electromotive force generated by the electric motor 3 at the end of the final step of monitoring the voltage impulse, and in particular of determining the amplitude of the stop time interval.

In essence, the method thus includes calculating a first characteristic parameter of the electromotive force generated by the electric motor 3. Such a first characteristic parameter corresponds to the amplitude of the stop time interval of the electric motor 3.

An acceptability limit value of the amplitude of the stop time interval of the electric motor 3 is determined in a first preliminary step of setting and adjusting, as a function of the type of electric motor that the production line communicates to the testing device 17 before starting the step of testing.

The testing method includes comparing the actual amplitude of the stop time interval of the electric motor 3 with the acceptability limit value of the amplitude of the stop time interval of the electric motor 3.

Such an interval of safety values has a predetermined amplitude. According to a first variant, the acceptability limit value of the amplitude of the stop time interval of the electric motor 3 is constant. According to a second variant, the acceptability limit of the stop time interval of the electric motor 3 is variable as a function of a plurality of parameters such as, for example, the test voltage, the ambient temperature, the duration of the voltage impulse, the number of times in which the testing process is repeated if the electric motor 3 is identified as unsuitable.

According to a preferred embodiment, the limit acceptability value of the amplitude of the stop time interval of the electric motor 3 to be tested is defined by observing a batch of electric motors 3 with the same features as the electric motor 3 to be tested but which do not comply with specifications, and a batch of electric motors 3 which comply with specifications with the same features as the electric motor 3 to be tested during a preliminary step of setting the method. The limit acceptability value of the amplitude of the stop time interval of the electric motor 3 is determined by observing the batch of electric motors 3 with the same features as the electric motors 3 to be tested but which do not comply with specifications, and the batch of electric motors 3 complying with specifications with the same features as the electric motor 3 to be tested.

In particular, the acceptability limit value of the amplitude of the stop time interval of the electric motor 3 is from 80 to 150 milliseconds.

Two conditions may occur as a function of the result of the comparison of the actual amplitude of the stop time interval of the electric motor 3 with the acceptability limit value of the amplitude of the stop time interval of the electric motor 3:
- if the actual amplitude of the stop time interval of the electric motor 3 is either greater than or equal to the acceptability limit value of the amplitude of the stop time interval of the electric motor 3, no fault of the stop time of the electric motor 3 is identified; and
- if the actual amplitude of the stop time interval of the electric motor 3 is lower than the acceptability limit value of the amplitude of the stop time interval of the electric motor 3, a fault of the stop time of the electric motor 3 is identified.

In particular, if the actual amplitude of the stop time interval of the electric motor 3 is lower than the acceptability limit value of the amplitude of the stop time interval of the electric motor 3 it means that the electric motor 3 has mechanical problems or frictions.

Once the supply of the voltage impulse of the electric motor 2 has ended and the electric motor 3 has been completely stopped, the testing device 17 provides for the available result of the test on the electric motor 3 by means of the external interface unit D with the operator of the testing device 17 and provides the available result of the testing procedure on the electric motor 3 for the production line by means of the interface unit A of the testing device 17.

The testing device 17 is obviously configured to indicate possible faults present in the electric motor 3 by means of the external interface unit D with the operator of the testing device 17; and is configured to indicate possible faults present in the electric motor 3 by means of the interface unit A to the production line to allow the line to reject the semi-installed throttle valve 1 automatically.

Furthermore, the testing device 17 is set up to identify the fault which can be found on the electric motor 3 to be tested by means of the external interface unit D with the operator of the testing device 17 from four possible identifiable faults (indicated in figure 3); furthermore, the testing device 17 is set up to identify the fault which can be found on the electric motor 3 to be tested by means of the interface unit A to the production line from the four possible identifiable faults (e.g. for subsequent statistic investigations), namely:
F1: average current value lower than the lower threshold value I_{lower} (and representative of electric problems such as, for example, a high contact resistance);
F2: average current value higher than the lower threshold value I_{higher} (and representative of electric problems such as, for example, a short-circuit or high internal friction);
F3: amplitude of the oscillation of the current signal of the electric motor 3 in the final step of the maximum voltage impulse Δₐₘₚ of the oscillation of the current signal of the electric motor 3 during the final step of the voltage impulse (and representative of irregular or localized frictions); and
F4: actual amplitude of the stop time interval of the electric motor 3 lower than the acceptability limit of the amplitude of the stop time interval of the electric motor 3 (representative of mechanical problems or frictions).

It is further possible to configure the testing device 17 so as to create statistics of the four possible faults found in the rejected electric motors 3.

According to a preferred variant, a safety number N, which represents the number of tests to be repeated by means of the testing device 17 if a fault is identified for establishing that the electric motor 3 is unsuitable for operation, is further determined during a preliminary step of setting and adjusting. According to a preferred embodiment, such a safety number N is equal to three. Thus, in essence, once the testing device 17 has diagnosed the presence of a fault, the testing process need to be repeated three times with the same result in order to confirm the faultiness of the electric motor 3. Thereby, it is possible to avoid rejecting electric motors 3 which are initially found to be faulty simply because this type of electric motor 3 require longer run-in time (because they have been stored for a long time) from the really faulty electric motors 3.

Moreover, it is possible to configure the testing device 17 to make the following items available for processing after the step of testing: the voltage of the electric motor 3, the non-filtered current signal of the electric motor 3 during the supply of the voltage impulse and/or the filtered current signal in the electric motor 3 during the supply of the voltage impulse by means of the analog interface E.

It is equally important to underline that the electric motor 3 is tested during a step of installing the actuator 1 of the internal combustion engine in which the pinion 3* of the electric motor 3 itself is free to rotate without any mechanical load.

In the above description, reference was always made to an electric motor 3 of the DC type but it is apparent that the above description may be advantageously applied to other types of electric motors.

The testing device 17 can test both electric motors 3 already installed on the actuator (but still disconnected from the transmission, in other words in which pinion 3* is free) and standalone electric motors 3 (as in the case of end-of-production line tests by the manufacturer of the electric motor 3). For those plants which produce actuators and/or valves, the step of testing the electric motor 3 should preferably be carried out when the electric motor 3 is already installed on the valve body 2, because the installation process may imply mechanical deformations of the electric motor 3 which could compromise functional features if it is not carried out correctly.

Furthermore, in the above description, reference was always made to an electric motor 3 configured to actuate a throttle valve 1 but it is apparent that the above description may be advantageously applied to other types of electric motors and to other types of valves and actuators provided with electric motors 3.

## Claims

1. A testing method for an electric motor (3) for an actuator (1) of an internal combustion engine provided with a pinion (3*); wherein the electric motor (3) is tested during a step of installing said actuator (1) of the internal combustion engine in which the pinion (3*) of the electric motor (3) itself is free to rotate without any mechanical load; the method comprises the steps of:
controlling the supply of a voltage impulse of predetermined duration and amplitude, which is variable as a function of the features of the electric motor (3) to be tested, to said electric motor (3);
calculating the actual stop time (Δtₛₜₒₚ) of the electric motor (3) at the end of the step of controlling the supply of a voltage impulse with a predetermined duration and amplitude to the electric motor (3); and
diagnosing the presence of faults in the electric motor (3) as a function of the actual stop time (Δtₛₜₒₚ) of the electric motor (3) at the end of the step of supplying a voltage impulse with a predetermined duration and amplitude to the electric motor (3);
the testing method is **characterized in that** it comprises the further steps of:
determining an acceptability limit value of the stop time of the motor (3) in a preliminary step of setting and adjusting;
comparing the acceptability limit value of the stop time with the actual stop time (Δtₛₜₒₚ) of the electric motor (3) at the end of the step of controlling the supply of a voltage impulse with a predetermined duration and amplitude to the electric motor (3); and
diagnosing the presence of faults in the electric motor (3) as a function of the comparison of the acceptability limit value of the stop time of the actual stop time (Δtₛₜₒₚ) of the electric motor (3) at the end of the step of controlling the supply of a voltage impulse with a predetermined duration and amplitude to the electric motor (3).

2. The testing method according to claim 1 and comprising the further step of identifying the presence of a fault in the electric motor (3) if the actual stop time (Δtₛₜₒₚ) of the electric motor (3) at the end of the step of controlling the supply of a voltage impulse with a predetermined duration and amplitude to the electric motor (3) is lower than the acceptability limit value of the stop time.

3. The testing method according claim 1 or 2, wherein the acceptability limit value of the stop time is variable over time as a function of a number of parameters chosen from: ambient temperature and duration of the voltage impulse.

4. The testing method according to claim 1 or 2, wherein the limit acceptability value of the stop time is constant.

5. The testing method according to any of the preceding claims, wherein the limit acceptability value of the stop time is from 80 to 150 milliseconds.

6. The testing method according to any of the preceding claims, and comprising the further steps of:
filtering the current signal of the electric motor (3) during the supply of a voltage impulse with a predetermined duration and amplitude at a relatively low cut-off frequency, preferably of the order of 40 Hz by means of a filter, preferably an eighth-order Bessel filter;
identifying a final phase of the step of controlling the supply of a voltage impulse to said electric motor (3) with a predetermined duration which is equal to at least one complete revolution of the pinion (3*) of the electric motor (3);
calculating the average value of the filtered current signal of the electric motor (3) and the amplitude of the oscillation of the filtered current signal of the electric motor (3) in the final phase of the step of controlling the supply of a voltage impulse to said electric motor (3); and
diagnosing the presence of faults in the electric motor (3) as a function of the average value of the filtered current signal and of the amplitude of the oscillation of the filtered current signal of the electric motor (3) in the final phase of the step of controlling the supply of a voltage impulse to said electric motor (3).

7. The testing method according to claim 6, wherein the duration of the final phase of the step of controlling the supply of a voltage impulse to said electric motor (3) is constant and from 30 to 50 milliseconds, preferably of 40 milliseconds.

8. The testing method according to claim 6 or 7, wherein the amplitude of the voltage impulse to be supplied to the electric motor (3) is lower than the nominal supply voltage of the electric motor (3).

9. The testing method according to claim 6 or 7 or 8, wherein the step of controlling the supply of a voltage impulse with a predetermined duration and amplitude to said electric motor (3) involves supplying a voltage of 4 volts.

10. The testing method according to any of the claims from 6 to 9, wherein the step of testing the presence of faults in the electric motor (3) as a function of the average value of the filtered current signal and of the amplitude of the oscillation of the filtered current signal of the electric motor (3) in the final phase of the step of controlling the supply of a voltage impulse to said electric motor (3) comprises the sub-steps of:
determining a lower threshold value (I_{lower}) and an higher threshold value (I_{higher}) of the average value of the filtered current signal in a step of setting and adjusting;
comparing the average value of the filtered current signal with both the lower threshold value (I_{lower}) and the higher threshold value (I_{higher}); and
diagnosing the presence of faults in the electric motor (3) as a function of the comparison of the average value of the filtered current signal with the lower threshold value (I_{lower}) and the higher threshold value I_{higher}).

11. The testing method according to any of the claims from 6 to 10, wherein the step of diagnosing the presence of faults in the electric motor (3) as a function of the average value of the filtered current signal and of the amplitude of the oscillation of the filtered current signal of the electric motor (3) in the final phase of the step of controlling the supply of a voltage impulse to said electric motor (3) comprises the sub-steps of:
determining a maximum amplitude (Δₐₘₚ) of the oscillation of the filtered current signal of the electric motor (3) in the final phase of the voltage impulse in a preliminary step of setting and adjusting;
comparing the amplitude of the oscillation of the filtered current signal of the electric motor (3) in the final phase of the step of controlling the supply of a voltage impulse to the electric motor (3) with the maximum amplitude (Δₐₘₚ) of the oscillation of the filtered current signal of the electric motor (3) in the final phase of the voltage impulse; and
diagnosing the presence of faults in the electric motor (3) as a function of the comparison of the amplitude of the oscillation of the filtered current signal of the electric motor (3) in the final phase of the step of controlling the supply of a voltage impulse to the electric motor (3) with the maximum amplitude (Δₐₘₚ) of the oscillation of the filtered current signal of the electric motor (3) in the final phase of the voltage impulse.

12. The testing method according to any of the preceding claims and comprising the further steps of:
determining a safety value (N) in a preliminary step of setting and adjusting;
diagnosing the presence of a fault in the electric motor (3); and
validating the identification of the presence of a fault in the electric motor (3) if the presence of a fault in the electric motor (3) is identified for a number of consecutive times equal to at least the safety value (N).

## Patentansprüche

1. Testverfahren für einen Elektromotor (3) für ein Stellglied (1) eines Verbrennungsmotors, der mit einem Ritzel (3*) versehen ist; wobei der Elektromotor (3) während eines Schrittes des Installierens des Stellgliedes (1) des Verbrennungsmotors, bei dem das Ritzel (3*) des Elektromotors (3) selbst sich ohne jede mechanische Last frei drehen kann, getestet wird; das Verfahren beinhaltet folgende Schritte:
Regeln der Zufuhr eines Spannungsimpulses von vorgegebener Dauer und Amplitude, der in Abhängigkeit von den Merkmalen des zu testenden Elektromotors (3) veränderlich ist, zu jenem Elektromotor (3);
Berechnen der tatsächlichen Stoppzeit (Δtₛₜₒₚ) des Elektromotors (3) am Ende des Schrittes des Regelns der Zufuhr eines Spannungsimpulses mit einer vorgegebenen Dauer und Amplitude zum Elektromotor (3); und
Diagnostizieren des Vorhandenseins von Fehlern im Elektromotor (3) in Abhängigkeit von der tatsächlichen Stoppzeit (Δtₛₜₒₚ) des Elektromotors (3) am Ende des Schrittes des Zuführens eines Spannungsimpulses mit einer vorgegebenen Dauer und Amplitude zum Elektromotor (3);
das Testverfahren ist **dadurch gekennzeichnet, dass** es die weiteren Schritte beinhaltet:
Bestimmen eines Zulässigkeitsgrenzwertes der Stoppzeit des Motors (3) in einem vorläufigen Schritt des Einstellens und Anpassens;
Vergleichen des Zulässigkeitsgrenzwertes der Stoppzeit mit der tatsächlichen Stoppzeit (Δtₛₜₒₚ) des Elektromotors (3) am Ende des Schrittes des Regelns der Zufuhr eines Spannungsimpulses mit einer vorgegebenen Dauer und Amplitude zum Elektromotor (3); und
Diagnostizieren des Vorhandenseins von Fehlern im Elektromotor (3) in Abhängigkeit vom Vergleich des Zulässigkeitsgrenzwertes der Stoppzeit der tatsächlichen Stoppzeit (Δtₛₜₒₚ) des Elektromotors (3) am Ende des Schrittes des Regelns der Zufuhr eines Spannungsimpulses mit einer vorgegebenen Dauer und Amplitude zum Elektromotor (3).

2. Testverfahren nach Anspruch 1 und den weiteren Schritt beinhaltend, bei dem das Vorhandensein eines Fehlers im Elektromotor (3) erkannt wird, falls die tatsächliche Stoppzeit (Δtₛₜₒₚ) des Elektromotors (3) am Ende des Schrittes des Regelns der Zufuhr eines Spannungsimpulses mit einer vorgegebenen Dauer und Amplitude zum Elektromotor (3) kürzer als der Zulässigkeitsgrenzwert der Stoppzeit ist.

3. Testverfahren nach Anspruch 1 oder 2, wobei der Zulässigkeitsgrenzwert der Stoppzeit über die Zeit in Abhängigkeit von einer Zahl von Parametern, die gewählt werden aus: Umgebungstemperatur und Dauer des Spannungsimpulses, veränderlich ist.

4. Testverfahren nach Anspruch 1 oder 2, wobei der Zulässigkeitsgrenzwert der Stoppzeit konstant ist.

5. Testverfahren nach einem der vorangegangenen Ansprüche, wobei der Zulässigkeitsgrenzwert der Stoppzeit von 80 bis 150 Millisekunden beträgt.

6. Testverfahren nach einem der vorangegangenen Ansprüche und die weiteren Schritte beinhaltend:
Filtern des Stromsignals des Elektromotors (3) während der Zufuhr eines Spannungsimpulses mit einer vorgegebenen Dauer und Amplitude zum Elektromotor (3) bei einer relativ niedrigen Grenzfrequenz, vorzugsweise in der Größenordnung von 40 Hz mittels eines Filters, vorzugsweise eines Bessel-Filters achter Ordnung;
Erkennen einer Schlussphase des Schrittes des Regelns der Zufuhr eines Spannungsimpulses mit einer vorgegebenen Dauer zum Elektromotor (3), die mindestens einer vollständigen Umdrehung des Ritzels (3*) des Elektromotors (3) entspricht;
Berechnen des durchschnittlichen Wertes des gefilterten Stromsignals des Elektromotors (3) und der Amplitude der Schwingung des gefilterten Stromsignals des Elektromotors (3) in der Schlussphase des Schrittes des Regelns der Zufuhr eines Spannungsimpulses zum Elektromotor (3); und
Diagnostizieren des Vorhandenseins von Fehlern im Elektromotor (3) in Abhängigkeit vom durchschnittlichen Wert des gefilterten Stromsignals und von der Amplitude der Schwingung des gefilterten Stromsignals des Elektromotors (3) in der Schlussphase des Schrittes des Regelns der Zufuhr eines Spannungsimpulses zum Elektromotor (3).

7. Testverfahren nach Anspruch 6, wobei die Dauer der Schlussphase des Schrittes des Regelns der Zufuhr eines Spannungsimpulses zum Elektromotor (3) konstant ist und von 30 bis 50 Millisekunden, vorzugsweise 40 Millisekunden, beträgt.

8. Testverfahren nach Anspruch 6 oder 7, wobei die Amplitude des dem Elektromotor (3) zuzuführenden Spannungsimpulses niedriger als die Nennversorgungsspannung des Elektromotors (3) ist.

9. Testverfahren nach Anspruch 6 oder 7 oder 8, wobei zum Schritt des Regelns der Zufuhr eines Spannungsimpulses mit einer vorgegebenen Dauer und Amplitude zum Elektromotor (3) das Zuführen einer Spannung von 4 Volt gehört.

10. Testverfahren nach einem der Ansprüche von 6 bis 9, wobei der Schritt des Testens auf das Vorhandensein von Fehlern im Elektromotor (3) in Abhängigkeit vom durchschnittlichen Wert des gefilterten Stromsignals und von der Amplitude der Schwingung des gefilterten Stromsignals des Elektromotors (3) in der Schlussphase des Schrittes des Regelns der Zufuhr eines Spannungsimpulses zum Elektromotor (3) folgende Teilschritte beinhaltet:
Bestimmen eines unteren Schwellenwertes (I_{lower}) und eines höheren Schwellenwertes (I_{higher}) des durchschnittlichen Wertes des gefilterten Stromsignals in einem Schritt des Einstellens und Anpassens;
Vergleichen des durchschnittlichen Wertes des gefilterten Stromsignals sowohl mit dem unteren Schwellenwert (I_{lower}) als auch mit dem höheren Schwellenwert (I_{higher}); und
Diagnostizieren des Vorhandenseins von Fehlern im Elektromotor (3) in Abhängigkeit vom Vergleich des durchschnittlichen Wertes des gefilterten Stromsignals mit dem unteren Schwellenwert (I_{lower}) und dem höheren Schwellenwert (I_{higher}).

11. Testverfahren nach einem der Ansprüche von 6 bis 10, wobei der Schritt des Diagnostizierens des Vorhandenseins von Fehlern im Elektromotor (3) in Abhängigkeit vom durchschnittlichen Wert des gefilterten Stromsignals und von der Amplitude der Schwingung des gefilterten Stromsignals des Elektromotors (3) in der Schlussphase des Schrittes des Regelns der Zufuhr eines Spannungsimpulses zum Elektromotor (3) folgende Teilschritte beinhaltet:
Bestimmen einer maximalen Amplitude (Δₐₘₚ) der Schwingung des gefilterten Stromsignals des Elektromotors (3) in der Schlussphase des Stromimpulses in einem vorläufigen Schritt des Einstellens und Anpassens;
Vergleichen der Amplitude der Schwingung des gefilterten Stromsignals des Elektromotors (3) in der Schlussphase des Schrittes des Regelns der Zufuhr eines Spannungsimpulses zum Elektromotor (3) mit der maximalen Amplitude (Δₐₘₚ) der Schwingung des gefilterten Stromsignals des Elektromotors (3) in der Schlussphase des Spannungsimpulses; und
Diagnostizieren des Vorhandenseins von Fehlern im Elektromotor (3) in Abhängigkeit vom Vergleich der Amplitude der Schwingung des gefilterten Stromsignals des Elektromotors (3) in der Schlussphase des Schrittes des Regelns der Zufuhr eines Spannungsimpulses zum Elektromotor (3) mit der maximalen Amplitude (Δₐₘₚ) der Schwingung des gefilterten Stromsignals des Elektromotors (3) in der Schlussphase des Spannungsimpulses.

12. Testverfahren nach einem der vorangegangenen Ansprüche und die weiteren Schritte beinhaltend:
Bestimmen eines Sicherheitswertes (N) in einem vorläufigen Schritt des Einstellens und Anpassens;
Diagnostizieren des Vorhandenseins eines Fehlers im Elektromotor (3); und
Validieren des Erkennens des Vorhandenseins eines Fehlers im Elektromotor (3), falls das Vorhandensein eines Fehlers im Elektromotor (3) für eine Zahl aufeinanderfolgender Male, die mindestens dem Sicherheitswert (N) entspricht, erkannt wird.

## Revendications

1. Procédé de test pour un moteur électrique (3) pour un actionneur (1) d'un moteur à combustion interne muni d'un pignon (3*) ; dans lequel le moteur électrique (3) est testé durant une étape d'installation dudit actionneur (1) du moteur à combustion interne dans lequel le pignon (3*) du moteur électrique (3) lui-même est libre de tourner sans aucune charge mécanique ; le procédé comprenant les étapes consistant à :
commander la délivrance d'une impulsion de tension de durée et d'amplitude prédéterminées, qui est variable en fonction des caractéristiques du moteur électrique (3) à tester, audit moteur électrique (3) ;
calculer le temps d'arrêt effectif (Δtₛₜₒₚ) du moteur électrique (3) à la fin de l'étape de commande de la délivrance d'une impulsion de tension avec une durée et une amplitude prédéterminées au moteur électrique (3) ; et
diagnostiquer la présence de défauts dans le moteur électrique (3) en fonction du temps d'arrêt effectif (Δtₛₜₒₚ) du moteur électrique (3) à la fin de l'étape de délivrance d'une impulsion de tension avec une durée et une amplitude prédéterminées au moteur électrique (3) ;
le procédé de test étant **caractérisé en ce qu'**il comprend les étapes supplémentaires consistant à :
déterminer une valeur de limite d'acceptabilité du temps d'arrêt du moteur (3) dans une étape préliminaire de réglage et d'ajustement ;
comparer la valeur de limite d'acceptabilité du temps d'arrêt au temps d'arrêt effectif (Δtₛₜₒₚ) du moteur électrique (3) à la fin de l'étape de commande de la délivrance d'une impulsion de tension avec une durée et une amplitude prédéterminées au moteur électrique (3) ; et
diagnostiquer la présence de défauts dans le moteur électrique (3) en fonction de la comparaison de la valeur de limite d'acceptabilité du temps d'arrêt et du temps d'arrêt effectif (Δtₛₜₒₚ) du moteur électrique (3) à la fin de l'étape de commande de la délivrance d'une impulsion de tension avec une durée et une amplitude prédéterminées au moteur électrique (3).

2. Procédé de test selon la revendication 1, et comprenant l'étape supplémentaire d'identification de la présence d'un défaut dans le moteur électrique (3) si le temps d'arrêt effectif (Δtₛₜₒₚ) du moteur électrique (3) à la fin de l'étape de commande de la délivrance d'une impulsion de tension avec une durée et une amplitude prédéterminées au moteur électrique (3) est inférieur à la valeur de limite d'acceptabilité du temps d'arrêt.

3. Procédé de test selon la revendication 1 ou 2, dans lequel la valeur de limite d'acceptabilité du temps d'arrêt est variable au cours du temps en fonction d'un certain nombre de paramètres choisis parmi : la température ambiante et la durée de l'impulsion de tension.

4. Procédé de test selon la revendication 1 ou 2, dans lequel la valeur de limite d'acceptabilité du temps d'arrêt est constante.

5. Procédé de test selon l'une quelconque des revendications précédentes, dans lequel la valeur de limite d'acceptabilité du temps d'arrêt est comprise entre 80 et 150 millisecondes.

6. Procédé de test selon l'une quelconque des revendications précédentes, et comprenant les étapes supplémentaires consistant à :
filtrer le signal de courant du moteur électrique (3) durant la délivrance d'une impulsion de tension avec une durée et une amplitude prédéterminées avec une fréquence de coupure relativement basse, de préférence de l'ordre de 40 Hz, à l'aide d'un filtre, de préférence un filtre de Bessel du huitième ordre ;
identifier une phase finale de l'étape de commande de la délivrance d'une impulsion de tension audit moteur électrique (3) avec une durée prédéterminée qui est égale à au moins une révolution complète du pignon (3*) du moteur électrique (3) ;
calculer la valeur moyenne du signal de courant filtré du moteur électrique (3) et de l'amplitude de l'oscillation du signal de courant filtré du moteur électrique (3) dans la phase finale de l'étape de commande de la délivrance d'une impulsion de tension audit moteur électrique (3) ; et
diagnostiquer la présence de défauts dans le moteur électrique (3) en fonction de la valeur moyenne du signal de courant filtré et de l'amplitude de l'oscillation du signal de courant filtré du moteur électrique (3) dans la phase finale de l'étape de commande de la délivrance d'une impulsion de tension audit moteur électrique (3).

7. Procédé de test selon la revendication 6, dans lequel la durée de la phase finale de l'étape de commande de la délivrance d'une impulsion de tension audit moteur électrique (3) est constante et comprise entre 30 et 50 millisecondes, de préférence égale à 40 millisecondes.

8. Procédé de test selon la revendication 6 ou 7, dans lequel l'amplitude de l'impulsion de tension à délivrer au moteur électrique (3) est inférieure à la tension d'alimentation nominale du moteur électrique (3).

9. Procédé de test selon la revendication 6 ou 7 ou 8, dans lequel l'étape de commande de la délivrance d'une impulsion de tension avec une durée et une amplitude prédéterminées audit moteur électrique (3) comprend la délivrance d'une tension de 4 volts.

10. Procédé de test selon l'une quelconque des revendications 6 à 9, dans lequel l'étape de test de la présence de défauts dans le moteur électrique (3) en fonction de la valeur moyenne du signal de courant filtré et de l'amplitude de l'oscillation du signal de courant filtré du moteur électrique (3) dans la phase finale de l'étape de commande de la délivrance d'une impulsion de tension audit moteur électrique (3) comprend les sous-étapes consistant à :
déterminer une valeur de seuil inférieure (I_{lower}) et une valeur de seuil supérieure (I_{higher}) de la valeur moyenne du signal de courant filtré dans une étape de réglage et d'ajustement ;
comparer la valeur moyenne du signal de courant filtré à la fois à la valeur de seuil inférieure (I_{lower}) et à la valeur de seuil supérieure (I_{higher}) et
diagnostiquer la présence de défauts dans le moteur électrique (3) en fonction de la comparaison de la valeur moyenne du signal de courant filtré à la valeur de seuil inférieure (I_{lower}) et à la valeur de seuil supérieure (I_{higher}).

11. Procédé de test selon l'une quelconque des revendications 6 à 10, dans lequel l'étape de diagnostic de la présence de défauts dans le moteur électrique (3) en fonction de la valeur moyenne du signal de courant filtré et de l'amplitude de l'oscillation du signal de courant filtré du moteur électrique (3) dans la phase finale de l'étape de commande de la délivrance d'une impulsion de tension audit moteur électrique (3) comprend les sous-étapes consistant à :
déterminer une amplitude maximale (Δₐₘₚ) de l'oscillation du signal de courant filtré du moteur électrique (3) dans la phase finale de l'impulsion de tension dans une étape préliminaire de réglage et d'ajustement ;
comparer l'amplitude de l'oscillation du signal de courant filtré du moteur électrique (3) dans la phase finale de l'étape de commande de la délivrance d'une impulsion de tension au moteur électrique (3) à l'amplitude maximale (Δₐₘₚ) de l'oscillation du signal de courant filtré du moteur électrique (3) dans la phase finale de l'impulsion de tension ; et
diagnostiquer la présence de défauts dans le moteur électrique (3) en fonction de la comparaison de l'amplitude de l'oscillation du signal de courant filtré du moteur électrique (3) dans la phase finale de l'étape de commande de la délivrance d'une impulsion de tension au moteur électrique (3) à l'amplitude maximale (Δₐₘₚ) de l'oscillation du signal de courant filtré du moteur électrique (3) dans la phase finale de l'impulsion de tension.

12. Procédé de test selon l'une quelconque des revendications précédentes, et comprenant les étapes supplémentaires consistant à :
déterminer une valeur de sécurité (N) dans une étape préliminaire de réglage et d'ajustement ;
diagnostiquer la présence d'un défaut dans le moteur électrique (3) ; et
valider l'identification de la présence d'un défaut dans le moteur électrique (3) si la présence d'un défaut dans le moteur électrique (3) est identifiée pendant un nombre de fois consécutives égal à au moins la valeur de sécurité (N).
